# EUROPEAN PATENT SPECIFICATION

(11) **EP 1 715 937 B1**
(45) Date of publication and mention of the grant of the patent: **10.04.2013**
(21) Application number: 05717757.8
(22) Date of filing: 18.02.2005
(51) Int. Cl.: B01D 53/70, B01D 53/68, B01J 19/08, B01J 19/12, C23C 16/44

(54) **METHODS AND APPARATUSES FOR TREATING A FLUOROCOMPOUND-CONTAINING GAS STREAM**
VERFAHREN UND VORRICHTUNGEN ZUR BEHANDLUNG EINES FLUORVERBINDUNGEN ENTHALTENDEN GASSTROMS
PROCEDES ET APPAREILS DE TRAITEMENT D'UN FLUX GAZEUX CONTENANT UN COMPOSE FLUORE

(30) Priority: 20.02.2004 GB 0403797
(43) Date of publication of application: 02.11.2006
(73) Proprietor: Edwards Limited, Crawley, West Sussex RH10 9LW (GB)
(72) Inventor: SMITH, James Robert, BOC Edwards, Clevedon, North Somerset BS21 6TH (GB); SEELEY, Andrew James, BOC Edwards, Clevedon, North Somerset BS21 6TH (GB); RADOIU, Marilena, Clevedon North Somerset BS21 6TH (GB)
(74) Representative: Clark, Charles Robert
(86) International application number: PCT/GB2005/000619
(87) International publication number: WO 2005/079958

(56) References cited:
- US-A1- 2003 000 823
- US-B1- 6 384 292
- US-B1- 6 673 323
- US-B1- 6 689 252

## Description

The present invention relates to gas abatement. The invention finds particular use in the abatement of gases exhaust from a process tool used in the semiconductor manufacturing industry.

CF₄, C₂F₆, C₃F₈, NF₃ and SF₆ are commonly used in the semiconductor manufacturing industry, for example, in dielectric film etching. Following the manufacturing process there is typically a residual perfluorocompound (PFC) content in the effluent gas pumped from the process tool. PFCs are difficult to remove from the effluent gas, and their release into the environment is undesirable because they are known to have relatively high greenhouse activity.

The object of abatement is to convert the PFCs into one or more compounds that can be more conveniently disposed of, for example, by conventional scrubbing.

Plasma abatement has proved to be an effective method for degradation of PFCs to less damaging species. Ih the plasma abatement process, an effluent gas containing the PFCs to be destroyed is caused to flow into a high density plasma. Under the intensive conditions within the plasma, the PFCs are subjected to impact with energetic electrons causing dissociation into reactive species. These species can combine with oxygen or hydrogen added to the effluent gas to produce relatively stable, low molecular weight by-products, for example, CO, CO₂ and HF, which can then be removed in a further treatment step utilising, for example, a wet scrubber to take the HF into aqueous solution.

However, known plasma abatement techniques tend to be relatively complex and have relatively high energy requirements. For example, in one known plasma abatement technique, the effluent gas stream is conveyed into a resonant cavity using microwave radiation to generate, from the PFCs, a microwave plasma. Another known technique is to convey the effluent stream into a dielectric tube, a high frequency surface-wave exciter being used to produce surface waves which generate a plasma within the tube to dissociate the PFCs.

US-B-6 689 252 describes another plasma based method of destroying PFCs by energising an effluent gas stream and oxygen in a reactor. US 2003/0000823 A1 and US-B-6673323 also describe plasma based methods of destroying PFCs.

In another PFC abatement technique, the effluent waste stream is brought into contact with a superheated stream of water vapour for reacting with the PFCs within the waste stream. However, such a technique not only requires heating of the water vapour to a temperature of at least 150°C, but also requires the effluent stream to be subsequently conveyed through a heat exchange mechanism to cool the stream before it is conveyed to a wet scrubber, the efficiency of the scrubber decreasing as a function of increasing temperature.

It is an aim of at least the preferred embodiment of the present invention to provide a relatively simple and efficient technique for treating a fluorocompound-containing stream.

In a first aspect, the present invention provides three methods of treating a fluorocompound-containing gas stream according to claims 1-3, the method comprising generating a plasma stream from a plasma source gas with a plasma generating means; then injecting the generated plasma stream through an aperture into a chamber, conveying to the plasma stream a source of OH⁻ and/or H⁺ ions for impinging upon the plasma stream to form heated OH⁻ and/or H⁺ ions, and conveying the fluorocompound-containing gas stream to the heated ions.

The present invention also provides three apparatuses of treating a fluorocompound-containing gas stream, according to claims 27-29.

As used herein, the term "fluorocompound" means any species comprising fluorine, and includes fluorocarbons, perfluorocompounds and hydrofluorocompounds, such as CF₄, C₂F₆, CHF₃, C₃Fₐ, and C₄F₈, that can be

converted into CO₂ and HF, which can be taken into solution in a wet scrubber. Other examples are NF₃, which can be converted into N₂ and HF, and SF₆, which can be converted into SO₂ and HF.

By providing a method in which heated OH⁻ and/or H⁺ ions are formed from a suitable source thereof, such as water or an alcohol, for subsequent reaction with a PFC component in an effluent gas stream, it has been found that the energy required to cause the destruction of the PFC component of the gas stream can be reduced, and the efficiency of that destruction can be radically improved. For example, H⁺ and OH- ions formed from the dissociation of water are capable of reacting with a PFC contained in the gas stream within a reaction chamber at ambient temperature, and thus at a much lower temperature than would be required if the water had not been pre-ionised before being introduced into the waste stream.

By injecting the plasma stream into the chamber through all aperture, another advantage is provided by not bringing the equipment used to generate the plasma stream into contact with either the effluent gas stream or any by-products from the reaction of the PFC with the OH- and/or H⁺ ions. As a result, any one of a range of equipment may be used to generate the plasma stream. In the preferred embodiment, a plasma is generated to decompose a plasma source gas to produce the plasma stream. For example, the plasma may be generated using a D.C source or radiation at a frequency of around 580 kHz, 13.56 MHz, 27 MHz, 915 MHz or 2.45 GHz to generate a plasma stream from the plasma source gas. Alternatively, a glow discharge may be generated to decompose the source gas. As is well known, a glow discharge is a luminous, thermal plasma formed by applying to a gas a voltage that is greater than the breakdown voltage of that gas. The plasma stream may also be generated by a discharge other than a glow discharge, for example by a corona discharge or an arc discharge. Such a discharge may be generated using a plasma gun, in which an electric arc is created between a water-cooled nozzle (anode) and a centrally located cathode. A stream of source gas, for example, an inert, ionisable gas such as nitrogen or argon, passes through the electric arc and is dissociated thereby. The plasma stream issuing from the nozzle resembles an open oxy-acetylene flame.

The plasma stream thus provides a dual role of (a) generating adequate species in the form of H⁺ and/or OH- ions that would then react with the PFC component of the gas stream, and (b) imparting heat as the initiation energy that enables the reaction between the ions and the PFC.

Further advantages are that a relatively cheap and readily available fluid, such as water vapour or a fuel, for example hydrogen, hydrocarbon or an alcohol, can be used to generate H⁺ and/or OH- ions, and that the reaction can take place at any convenient pressure, for example, around or below atmospheric pressure. Examples of a suitable alcohol include methanol, ethanol, propanol, propan-2-ol and butanol. Other examples of a source of H⁺ ions include hydrogen, a hydrocarbon, ammonia and a paraffin.

Various techniques may be used to form the ions using a plasma gun. In a first technique, a plasma stream is formed and, prior to the injection of the plasma stream into the chamber, water (as an example of a suitable source of these ions) is conveyed to the stream so that a flame containing these ions is injected into the chamber to abate the effluent gas stream within. The water may be conveyed to the plasma stream separately from the source gas, or within a fluid mixture comprising both water vapour and the source gas. In a second technique, both water and the effluent gas stream are separately conveyed into the chamber. The water is dissociated by the flame to form heated ions within the chamber, which ions subsequently react with the PFC component of the waste stream. In a third technique, the effluent gas stream is conveyed to the plasma stream prior to its injection into the reaction chamber, so that both the plasma stream and the gas stream, which may comprise the PFC and/or radicals generated from the PFC, are injected into the reaction chamber. Water may be conveyed to the plasma stream upstream from the aperture, that is, with one of the source gas or the effluent gas stream, or separately therefrom, or may be conveyed to the plasma stream downstream from the nozzle, for example, directly to the reaction chamber. In this case, the water may impinge upon the plasma stream to form heated ions within the chamber for reacting with the PFC and/or the PFC radicals, and/or may react directly with the PFC radicals within the chamber for abatement thereof. Thus, in another aspect the present invention provides a method of treating a fluorocompound-containing gas stream, the method comprising generating a plasma stream from a plasma source gas, adding the gas stream to the plasma stream, injecting the plasma stream and gas stream through an aperture into a reaction chamber, and conveying to the plasma stream a source of OH⁻ and/or H⁺ ions.

In the preferred embodiment, a single plasma gun is used to inject the plasma stream into the reaction chamber. However, a plurality of such guns may be provided to inject a plurality of plasma streams into the same chamber, each for abating a common or respective gas stream. Alternatively, a plurality of gas streams may be conveyed to a single chamber, into which a single plasma stream is injected. This can increase further the efficiency of the treatment of the waste stream. These guns may be connected to a common power source or to respective sources.

Depending on whether the chamber is connected to the inlet or the outlet of a pump for pumping the gas stream from, for example, a process tool, and the flow rate of the gas stream, the chamber may be at any pressure in the range from 10⁻³ mbar to 2000 mbar.

Depending on the nature of the reaction occurring within the chamber, the abatement of the fluorocompound within the gas stream may be promoted by heating the chamber, for example, to a temperature in the range from ambient to 1500°C. For example, the chamber may be heated to a temperature in the range from 400°C to 1500°C, more preferably in the range from 500°C to 1000°C.

The ion source may be injected into the chamber over a catalyst, for example, one of tungsten, silicon and iron.

The gas stream is preferably subsequently conveyed to a wet scrubber or a reactive solid media downstream from the chamber to remove one or more by-products from the reaction from the gas stream. The scrubber may be coupled close to the reaction chamber, or may be more remote from the reaction chamber.

As previously mentioned, the PFC may comprise a perfluorinated, or a hydrofluorocarbon, compound, for example, one of CF₄, C₂F₆, CHF₃, C₃F₈, C₄Fₐ, NF₃ and SF₆.

In another aspect, the present invention provides apparatus for treating a fluorocompound-containing gas stream, the apparatus comprising a reaction chamber, means for supplying a plasma source gas to a means for generating a plasma stream from said plasma source gas and injecting the generated plasma stream through an aperture into the chamber, means for conveying to the plasma stream a source of OH⁻ and/or H⁺ ions for impinging upon the plasma stream to form heated OH⁻ and/or H⁺ ions, and means for conveying the fluorocompound-containing gas stream to the heated ions.

The invention also provides a method of treating an effluent fluid stream from a semiconductor manufacturing process tool, the method comprising injecting an ionised fluid stream into a reaction chamber, and conveying the effluent fluid stream to the chamber, wherein the ionised fluid stream either contains reactive species for reacting with a component of the effluent fluid stream, or impinges upon a reactive fluid conveyed to the chamber to form the reactive species.

Features described above in relation to method aspects of the invention are equally applicable to apparatus aspects, and vice versa.

Preferred features of the present invention will now be described with reference to the accompanying drawings, in which:
Figure 1 illustrates schematically one example of a processing system;
Figure 2 illustrates schematically another example of a processing system;
Figure 3 illustrates the fluid supply to the plasma abatement device of the processing systems of Figure 1 or Figure 2;
Figure 4 illustrates in more detail the plasma abatement device of Figure 3;
Figure 5 is an illustration of one embodiment of a plasma torch suitable for use in the device of Figure 4;
Figure 6 illustrates the use of the torch of Figure 5 with a plurality of gas streams entering the abatement device;
Figure 7 is an illustration of a second embodiment of a plasma torch suitable for use in the device of Figure 4;
Figure 8 illustrates a third embodiment of a plasma torch suitable for use in the device of Figure 4; and
Figure 9 illustrates a fourth embodiment of a plasma torch suitable for use in the device of Figure 4.

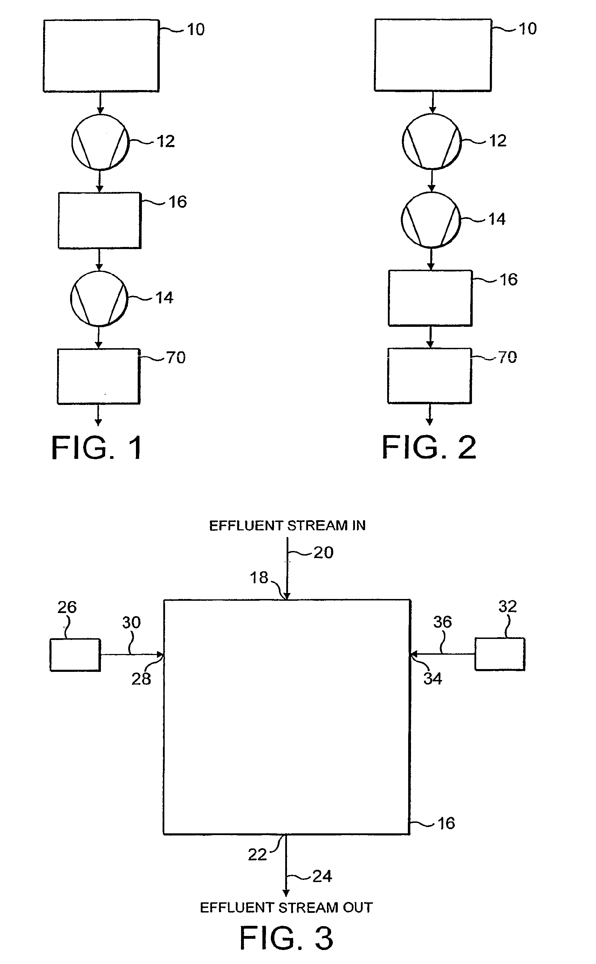

With reference first to Figure 1, a processing system for processing, for example, semiconductor or flat panel display devices, comprises a processing chamber 10 of a processing tool that receives various gases (not shown) for use in performing the processing within the chamber. One example of a processing tool is a plasma etch reactor, which receives an etchant gas for performing plasma etching of semiconductor wafers located within the processing chamber 10. Examples of suitable etchant include the perfluorocompounds (PFCs) having the general formula CₓF_{y} where x ≥ 1 and y ≥ 1, such as CF₄, C₂F₆, C₃F₈, and C₄F₈, although other etchants including hydrofluorocarbon gases, such as CHF₃, C₂HF₅ and CH₂F₂, NF₃, and SF₆ may be used. Other gases supplied to the processing chamber 10 may include oxygen as a reactant for reacting with the etchant, and unreactive noble gases, such as argon and helium.

An effluent gas stream is drawn from the outlet of the process chamber 10 by a pumping system. During the etching process, only a portion of the reactants will be consumed, and so the effluent gas stream exhaust from the outlet of the process chamber 10 will contain a mixture of the reactants, the unreactive noble gases supplied to the chamber, and by-products from the etch process.

The pumping system comprises a secondary pump 12, typically in the form of a turbomolecular pump, for drawing the effluent stream from the process chamber 10. The turbomolecular pump 12 can generate a vacuum of at least 10⁻³ mbar in the process chamber 10. The effluent stream is typically exhausted from the turbomolecular pump 12 at a pressure of around 1 mbar. In view of this, the pumping system also comprises a primary, or backing pump 14 for receiving the effluent stream exhaust from the turbomolecular pump 12 and raising the pressure of the effluent stream to a pressure around atmospheric pressure.

In order to remove the harmful PFC components from the effluent stream, the effluent stream is conveyed through a plasma abatement device 16. As illustrated in Figure 1, the abatement device 16 may located between the turbomolecular pump 12 and the backing pump 14, with the abatement thus being performed at a sub-atmospheric pressure, or, as illustrated in Figure 2, the abatement device 16 may be connected to the exhaust from the backing pump, with the abatement thus being performed at or around atmospheric pressure.

Figure 3 illustrates the gas supplies to the abatement device 16. The effluent stream is conveyed to a first inlet 18 of the abatement device 16 by conduit 20, and is conveyed from the outlet 22 of the abatement device 16 by conduit 24. A source of OH⁻ and/or H⁺ ions, in this example water, is supplied from a source 26 thereof to a second inlet 28 of the abatement device 16 by conduit 30, and an ionisable, plasma source gas, in this example nitrogen, is supplied from a source 32 thereof to a third inlet 34 of the abatement device by conduit 36.

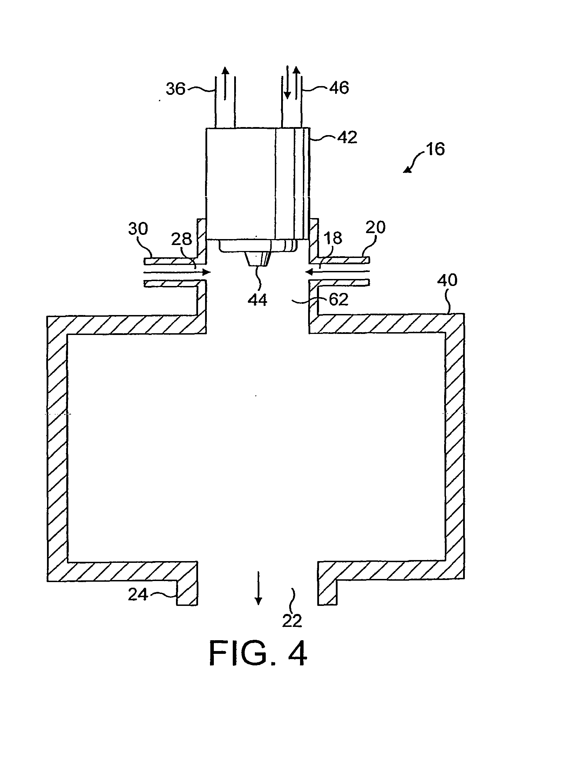

With reference to Figure 4 the abatement device 16 comprises a reaction chamber 40 in which are formed the first inlet 18 for receiving the effluent stream, the second inlet 28 for receiving the ion source, and the outlet 22 for exhausting from the chamber 40 a fluid stream containing by-products from the abatement process and other, unabated gases contained within the effluent stream entering the abatement device 16. The abatement device 16 further comprises a dc plasma torch 42 for receiving the nitrogen stream from the conduit 36 and generating a plasma stream that is injected into the chamber 40 in the form of a flame emitted from an aperture or nozzle 44 of the plasma torch 42. As shown in Figure 4, the plasma torch 42 also receives a flow of water coolant that enters and leaves the torch via a conduit system indicated generally at 46 in Figure 4.

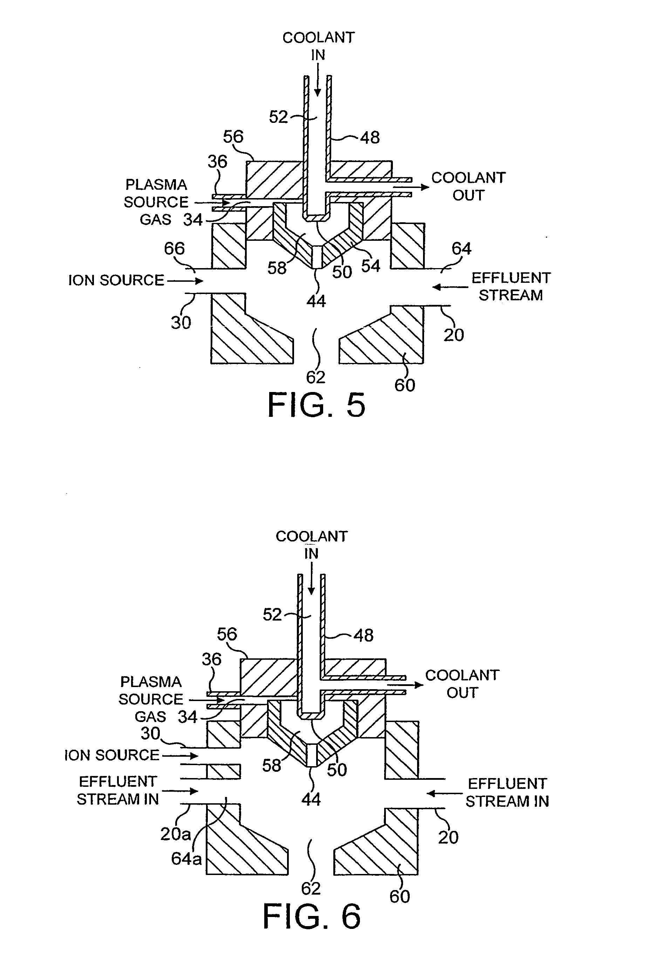

Figure 5 shows in more detail the configuration of one embodiment of the plasma torch 42. The plasma torch 42 comprises an elongate tubular cathode, or electron emitter, 48 having an end wall 50. Water coolant is conveyed through the bore 52 of the electron emitter 48 during use of the plasma torch 42. The bore 52 of the electron emitter 48 is aligned with the nozzle 44 formed in a start anode, or electrode 54 surrounding the end wall 50 of the electron emitter 48. The start electrode 54 is mounted in an insulating block 56 surrounding the electron emitter 48. A bore formed in the insulating block 56 provides the third inlet 34 of the abatement device, and conveys a stream of plasma source gas into a cavity 58 located between the end wall 50 of the electron emitter 48 and the start electrode 54.

In operation of the plasma torch 42, a pilot arc is first generated between the electron emitter 48 and the start electrode 54. The arc is generated by a high frequency, high voltage signal typically provided by a generator associated with the power supply for the torch. This signal induces a spark discharge in the plasma source gas flowing in the cavity 58, and this discharge provides a current path. The pilot arc thus formed between the electrode emitter 48 and the start electrode 54 ionises the plasma source gas passing through the nozzle 44 to produce a high momentum plasma flame of ionised source gas from the tip of the nozzle 44. The flame passes from the nozzle towards a secondary anode 60 surrounding the nozzle 44 to define a plasma region 62. The secondary anode 60 may be provided by part of the wall of the chamber 40, or may be a separate member inserted into the chamber 40, in which case the secondary anode 60 may be provided with apertures 64, 66 which align with the inlets 18, 28 of the chamber 40 to enable the ion source and the effluent stream to be conveyed to the plasma region 62. The lower (as illustrated) portion of the secondary anode 60 may be profiled as shown in Figure 5 to enable the secondary anode to be used instead of the start electrode 54 to generate the plasma stream from the plasma source gas.

In use, the ion source, in this example water, is dissociated by the plasma flame emitted from the nozzle 44 of the torch plasma 42 to form H⁺ and OH⁻ ions within the plasma region 62. These ions subsequently react within the chamber 40 with the PFC component(s) of the effluent stream entering the chamber 40. The by-products from the reaction, and any unabated noble gases contained within the effluent stream entering the chamber 40, are exhaust from the chamber 40 through outlet 22, and subsequently conveyed to a wet scrubber, solid reaction media, or other secondary abatement device 70, as illustrated in Figures 1 and 2 After passing through the abatement device 70, the effluent stream may be exhaust to the atmosphere.

Some examples of reactions occurring within the chamber 40 will now be described.

### Example 1

The reactive fluid is a source of H⁺ and OH⁻ ions, for example, water vapour, and the effluent stream contains a perfluorocompound, for example, CF₄. The plasma flame dissociates the water vapour into H⁺ and OH⁻ ions:

H₂O → H⁺ +OH⁻ (1)

which react with CF₄ to form carbon dioxide and HF as by-products:

CF₄ + 2OH⁻ + 2H⁺ → CO₂ + 4HF (2)

The HF contained within the stream exhaust from the abatement device can be taken into aqueous solution within the wet scrubber, or reacted with a solid reaction media to form a solid by-product which can be readily disposed of.

A typical gas mixture for performing a dielectric etch in a process tool may contain differing proportions of the gases CHF₃, C₃F₈, C₄F₈ or other perfluronated or hydrofluorocarbon gas, but the chemical reactions of the H⁺ and OH⁻ ions with these components of the waste gas stream will differ in detail but the general form will be as the scheme above.

### Example 2

The reactive fluid is again a source of H⁺ and OH⁻ ions, for example, water vapour, and the waste stream contains NF₃. Process tool manufacturers are increasingly adopting NF₃ as the chamber cleaning gas of choice for PECVD reactors. Whereas the utilisation of NF₃ by the cleaning process is much higher than that of either CF₄ or C₂F₆, the by-products produced are considerably, more reactive and their uncontrolled release is potentially very dangerous. Within the plasma, NF₃ dissociates to form N₂, F₂ and N₂F₄:

4NF₃ → N₂ + 4F₂ + N₂F₄ (3)

with the N₂F₄ component of the effluent stream subsequently reacting with the H⁺ and OH⁻ ions generated from the impingement of the water vapour on the plasma flare:

N₂F₄ + 2H⁺ + 2OH⁻ → N₂ + 4HF + O₂ (4)

to form by-products that can be readily disposed of.

### Example 3

It is normal practice to introduce materials such as silicon, phosphorus, arsenic into a process tool as both inorganic hydrides or organometallic compounds. Other materials such as silicon, tantalum, aluminium, copper are introduced into the process chamber as organometallic compounds. In other process steps by-products of reaction are known to make powders that are very reactive and present a substantial danger if they collect in quantity, as they have been known to spontaneously react causing equipment damage. The introduction of reactive ions directly into the waste gas has been shown to substantially reduce the reactivity of such compounds, rendering them safe for subsequent handling.

The reactions are further enhanced by maintaining the reaction chamber at an elevated temperature in the range of 400°C to 1500°C, but preferably in a temperature range 500°C to 1000°C.

As illustrated by the above examples, the same ions may be used to remove various different components from a gas stream. Consequently, the abatement device is suitable to receives a plurality of gas streams, either from similar or different process tools, and convert similar or different components of those gas streams into species that can be treated by the secondary abatement device 70. For example, as illustrated in Figure 6, the abatement device may be provided with an additional inlet for receiving an additional gas stream via conduit 20a, with an additional aperture 64a being provided in the secondary anode 60 to enable the additional gas stream to be conveyed to the plasma region 62.

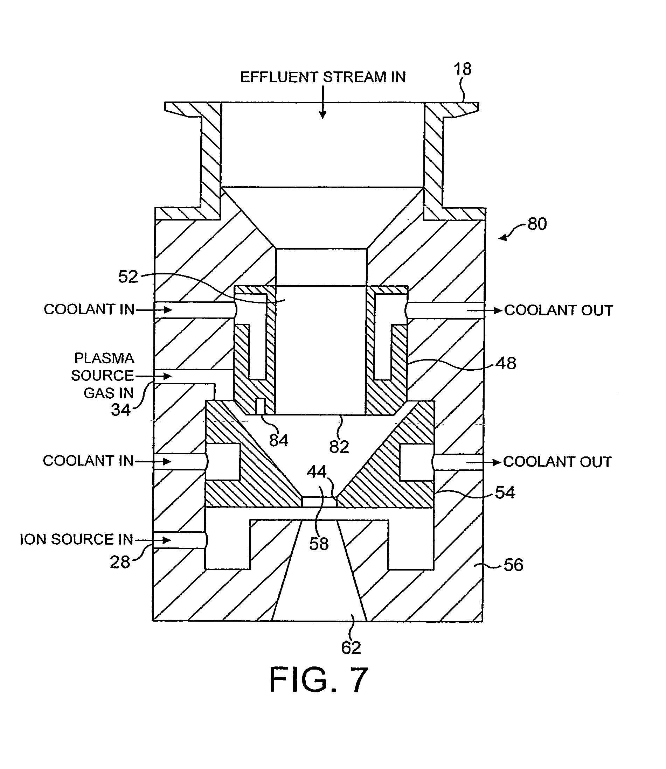

In Example 1 above, the ions react with the CF₄ component of the effluent stream entering the chamber 40, and so it is not essential for the effluent stream to pass through the plasma flare to decompose the CF₄ prior to reaction with the ions. In contrast, in Example 2 above, it is desirable to convey the effluent stream through the plasma stream in order to dissociate the NF₃ into species that are more reactive with the ions generated by the ion source. In the examples illustrated in Figures 4 to 6, the effluent stream may be conveyed into the chamber 40 proximate the plasma region 62 so that the PFC passes through the plasma region. Figure 7 illustrates an example of a plasma torch 80 in which the contact of the effluent stream with the plasma flare is maximised. In this example, the effluent stream is conveyed directly to the plasma torch 80, rather than into the reaction chamber 40. As shown in Figure 7, the effluent stream is conveyed from the first inlet 18 of the abatement device into the bore 52 of the electron emitter 48. The effluent stream passes from the open end 82 of the electron emitter 48 into the cavity 58 between the electron emitter 48 and the start electrode 54 of the plasma torch 80. The cavity 58 also receives a stream of plasma source gas entering the abatement device through the third inlet 34 formed in the electrically insulting block 56 surrounding both the electron emitter 48 and the start electrode 54.

In use, similar to the example illustrated in Figure 5, a pilot arc is first generated between the electron emitter 48 and the start electrode 54 by supplying a high frequency, high voltage signal to a hafnium insert 84. The pilot arc thus formed between the electrode emitter 48 and the start electrode 54 ionises the plasma source gas entering the cavity 58 from the third inlet 34 to produce a high momentum plasma flame of ionised source gas from the tip of the nozzle 44. As the effluent stream enters the cavity 58 from the open end 82 of the electron emitter 48, it mixes with the plasma source gas within the cavity 58 and is emitted from the nozzle 44 with the plasma stream into the plasma region 62. Water is supplied to the plasma region 62 from the second inlet 28, which in this example is also formed in the insulating block 56 of the torch 42. The water is decomposed by the plasma stream to form H⁺ and OH⁻ ions, which react with the PFC, and/or with species formed from the dissociation of the PFC by the plasma stream, within the reaction chamber.

It is to be understood that the foregoing represents various examples of the invention, others of which will no doubt occur to the skilled addressee without departing from the true scope of the invention as defined by the claims appended hereto.

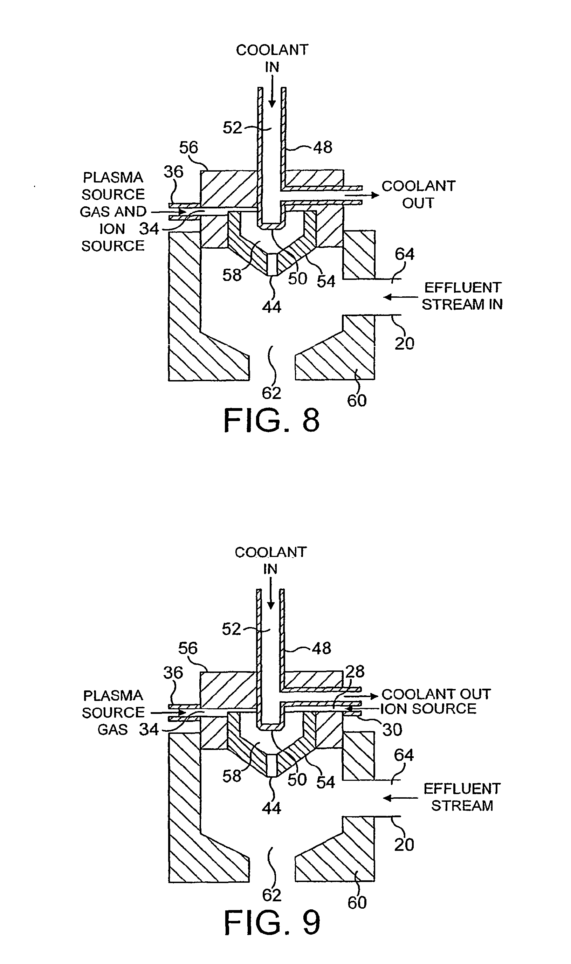

For example, whilst in the illustrated examples the plasma abatement device 16 has three separate inlets each for receiving a respective one of the effluent stream, ion source and plasma source gas, the number of inlets may be reduced by conveying, for example, the plasma source gas to the plasma torch in a stream also containing the ion source. Figure 8 illustrates a modification of the plasma torch shown in Figure 5 where the plasma source gas and the ion source are both conveyed to the plasma torch 42 through the inlet 34. Alternatively, as illustrated in Figure 9, the second inlet 28 may be configured to supply the ion source directly to the cavity 58 located between the electrodes 48, 54 of the plasma torch. In both of these modifications, the ion source enters the reaction chamber 40 through the nozzle in a dissociated state, that is, with the plasma stream injected into the reaction chamber containing the ions for reacting with the fluorocarbon component of the gas stream. Simiiariy, in the embodiment shown in Figure 7, the ion source may be conveyed to the plasma torch 80 with the plasma source gas, or it may be conveyed to the cavity 58 separately from the plasma source gas. As another alternative, the ion source may be conveyed to the plasma torch 80 mixed with the effluent stream, as under normal conditions the ion source is not reactive with the PFC component of the effluent stream.

## Claims

1. A method of treating a fluorocompound-containing gas stream, the method comprising generating a plasma stream from a plasma source gas (32), injecting the generated plasma stream through an aperture (44) into a chamber (40), **and prior to the injection of the plasma stream into the chamber (40)** conveying to the plasma stream a source (26) of OH⁻ and/or H⁺ ions for impinging upon the plasma stream to form heated OH⁻ and/or H⁺ ions, **and directly conveying the gas stream to the chamber (40) for reacting with the heated ions therein.**

2. A method of treating a fluorocompound-containing gas stream, the method comprising generating a plasma stream from a plasma source gas (32), injecting the generated plasma stream through an aperture (44) into a chamber (40), conveying to the plasma stream a source (26) of OH⁻ and/or H⁺ ions for impinging upon the plasma stream to form heated OH⁻ and/or H⁺ ions, **wherein the ion source (26) is conveyed to_the_chamber (40),** and **directly conveying the gas stream to the chamber (40) for reacting with the heated ions therein.**

3. A method of treating a fluorocompound-containing gas stream, the method comprising generating a plasma stream from a plasma source gas (32), injecting the generated plasma stream through an aperture (44) into a chamber (40), conveying to the plasma stream a source (26) of OH⁻ and/or H⁺ ions for impinging upon the plasma stream to form heated OH⁻ and/or H⁺ ions, and conveying the gas stream to the heated ions **through the plasma stream, wherein the gas stream is conveyed to the plasma stream for injection into the chamber therewith.**

4. A method according to any preceding Claim, wherein the plasma source gas (32) comprises an inert ionisable gas, for example, one of nitrogen and argon.

5. A method according to any preceding Claim, wherein the plasma stream is formed by generating an electric field between two electrodes (48, 54 or 60), and conveying the plasma source gas (32) between the electrodes to form the plasma stream.

6. A method according to Claim 5, wherein one of the electrodes (60) provides at least part of a wall of said chamber (40).

7. A method according to Claim 5 or Claim 6, wherein the plasma stream is injected into the chamber (40) through an aperture (44) formed in one of the electrodes (54 or 60).

8. A method according to any of Claims 1, 4, 5, 6 and 7, wherein the ion source (26) is conveyed to the plasma stream in a stream comprising the plasma source gas (32).

9. A method according to any of Claims 1, 4, 5, 6 and 7, wherein the ion source (26) is conveyed to the plasma stream separately from the plasma source gas (32).

10. A method according to any of Claims 2, 4, 5, 6 and 7, wherein the ion source (26) is conveyed into the chamber (40) separately from the gas stream.

11. A method according to any preceding claim, wherein the gas stream is conveyed to the chamber separately from the plasma stream.

12. A method according to Claim 3, wherein the ion source (26) is conveyed to the plasma stream within the gas stream

13. A method according to any preceding claim, wherein the plasma stream is generated around or below atmospheric pressure.

14. A method according to any preceding claim, wherein the plasma stream is generated using a dc plasma torch (42).

15. A method according to any preceding claim, wherein the ion source (26) comprises one of water and water vapour.

16. A method according to any of Claims 1 to 14, wherein the ion source (26) comprises an alcohol, for example one of methanol, ethanol, propanol, propan-2-ol and butanol.

17. A method according to any of Claims 1 to 14, wherein the ion source (26) comprises one of hydrogen, a hydrocarbon, ammonia, and a paraffin.

18. A method according to any preceding claim, wherein the chamber (40) is at a temperature in the range from ambient to 1200°C.

19. A method according to any preceding claim, wherein the chamber (40) is at ambient temperature.

20. A method according to any of Claims 1 to 18, wherein the chamber (40) is at a temperature in the range from 400°C to 1000°C.

21. A method according to any preceding claim, wherein the chamber (40) is at a pressure in the range from 10⁻³ mbar to 2000 mbar.

22. A method according to any preceding claim, wherein the ion source (26) is conveyed into the chamber over a catalyst.

23. A method according to Claim 22, wherein the catalyst comprises one of tungsten, silicon iron, rhodium and platinum.

24. A method according to any preceding claim, wherein the gas stream is subsequently conveyed from the chamber (40) to a wet scrubber (70).

25. A method according to any preceding claim, wherein the gas stream is subsequently conveyed from the chamber (40) to a reactive media (70).

26. A method according to any preceding claim, wherein the perfluorocompound comprises one of CF₄, C₂F₆, CHF₃, C₃F₈, C₄F₈, NF₃ and SF₆.

27. Apparatus for treating a fluorocompound-containing gas stream, the apparatus comprising a reaction chamber (40), means (42) for generating a plasma stream from a plasma source gas and injecting the generated plasma stream through an aperture (44) into the chamber (40), means (30, 28) for conveying to the plasma stream a source (26) of OH⁻ and/or H⁺ ions for impinging upon the plasma stream to form heated OH⁻ and/or H⁺ ions, and means (18, 20) for conveying the gas stream to the heated ions, **wherein the means (28, 30) for conveying the source of OH⁻ and/or H⁺ ions is arranged to convey the source of OH⁻ and/or H⁺ ions to the plasma stream prior to the injection of the plasma stream into the chamber (401, and the means (18, 20) for conveying the gas stream to the heated OH⁻ and/or H⁺ ions is arranged to convey the gas stream directly to the chamber (40).**

28. Apparatus for treating a fluorocompound-containing gas stream, the apparatus comprising a reaction chamber (40), means (42) for generating a plasma stream from a plasma source gas and injecting the generated plasma stream through an aperture (44) into the chamber (40), means (30, 28) for conveying to the plasma stream a source (26) of OH⁻ and/or H⁺ ions for impinging upon the plasma stream to form heated OH⁻ and/or H⁺ ions, and means (18, 20) for conveying the gas stream to the heated ions, **wherein the means (28, 30) for conveying the source of OH⁻ and/or H⁺ ions is arranged to convey the source of OH⁻ and/or H⁺ ions to the chamber (40), and the means (18, 20) for conveying the gas stream to the heated OH⁻ and/or H⁺ ions is arranged to convey the gas stream directly to the chamber (40).**

29. Apparatus for treating a fluorocompound-containing gas stream, the apparatus comprising a reaction chamber (40), means (42) for generating a plasma stream from a plasma source gas and injecting the generated plasma stream through an aperture (44) into the chamber (40), means (30, 28) for conveying to the plasma stream a source (26) of OH⁻ and/or H⁺ ions for impinging upon the plasma stream to form heated OH⁻ and/or H⁺ ions, and means (18, 20) for conveying the gas stream to the heated ions, **wherein the means (18, 20) for conveying the gas stream to the heated OH⁻ and/or H⁺ ions is arranged to convey the gas stream to the chamber (40) through the aperture (44) with the plasma stream**

30. Apparatus according to Claims 27, 28 and 29, wherein the means (42) for generating a plasma stream comprises means for generating an electric field between two electrodes (48, 54 or 60), and means for conveying the plasma source gas between the electrodes (48, 54 or 60) to form the plasma stream.

31. Apparatus according to Claim 30, wherein one of the electrodes (60) provides at least part of a wall of said chamber.

32. Apparatus according to Claim 30 or Claim 31, wherein the aperture (44) is located in one of the electrodes (54).

33. Apparatus according to any of Claims 27 to 32, wherein the means (28, 30) for conveying the source of OH⁻ and/or H⁺ ions to the plasma stream is separate from the means (18, 20) for conveying the gas stream to the heated OH⁻ and/or H⁺ ions.

## Patentansprüche

1. Verfahren zum Behandeln eines eine Fluorverbindung enthaltenden Gasstroms, wobei das Verfahren das Erzeugen eines Plasmastroms aus einem Plasmaquellengas (32), das Einleiten des erzeugten Plasmastroms durch eine Öffnung (44) in eine Kammer (40), und vor dem Einleiten des Plasmastroms in die Kammer (40) das Fördern einer Quelle (26) von OH⁻- und/oder H⁺-Ionen in dem Plasmastrom zum Auftreffen auf den Plasmastrom zur Bildung von erhitzten OH-- und/oder H⁺-Ionen, und das direkte Fördern des Gasstroms zu der Kammer (40) zum Reagieren mit den darin befindlichen erhitzten Ionen umfasst.

2. Verfahren zum Behandeln eines eine Fluorverbindung enthaltenden Gasstroms, wobei das Verfahren das Erzeugen eines Plasmastroms aus einem Plasmaquellengas (32), das Einleiten des erzeugten Plasmastroms durch eine Öffnung (44) in eine Kammer (40), das Fördern einer Quelle (26) von OH-- und/oder H⁺-Ionen in dem Plasmastrom zum Auftreffen auf den Plasmastrom zum Bilden von erhitzten OH⁻- und/oder H⁺-Ionen aufweist, wobei die Ionenquelle (26) zu der Kammer (40) gefördert wird, und das direkte Fördern des Gasstroms zu der Kammer (40) zum Reagieren mit den darin befindlichen erhitzten Ionen umfasst.

3. Verfahren zum Behandeln eines eine Fluorverbindung enthaltenden Gasstroms, wobei das Verfahren das Erzeugen eines Plasmastroms aus einem Plasmaquellengas (32), das Einleiten des erzeugten Plasmastroms durch eine Öffnung (44) in eine Kammer (40), das Fördern einer Quelle (26) von OH-- und/oder H⁺-Ionen in den Plasmastrom zum Auftreffen auf dem Plasmastrom zum Bilden erhitzter OH⁻- und/oder H⁺-Ionen, und das Fördern des Gasstroms zu den erhitzten Ionen durch den Plasmastrom umfasst, wobei der Gasstrom zu dem Plasmastrom zum Einleiten zusammen damit in die Kammer gefördert wird.

4. Verfahren nach irgendeinem vorhergehenden Anspruch, wobei das Plasmaquellengas (32) ein inertes ionisierbares Gas, beispielsweise Stickstoff oder Argon, ist.

5. Verfahren nach irgendeinem vorhergehenden Anspruch, wobei der Plasmastrom durch Erzeugen eines elektrischen Felds zwischen zwei Elektroden (48, 54 oder 60) und Fördern des Plasmaquellengases (32) zwischen den Elektroden hindurch zur Bildung des Plasmastroms gebildet wird.

6. Verfahren nach Anspruch 5, wobei eine der Elektroden (60) mindestens einen Teil einer Wand der genannten Kammer (40) bildet.

7. Verfahren nach Anspruch 5 oder Anspruch 6, wobei der Plasmastrom in die Kammer (40) durch eine Öffnung (44) eingeleitet wird, die in einer der Elektroden (54 oder 60) gebildet ist.

8. Verfahren nach einem der Ansprüche 1, 4, 5, 6 und 7, wobei die Ionenquelle (26) zu dem Plasmastrom in einem das Plasmaquellengas (32) umfassenden Strom gefördert wird.

9. Verfahren nach einem der Ansprüche 1, 4, 5, 6 und 7, wobei die Ionenquelle (26) zu dem Plasmastrom gesondert von dem Plasmaquellengas (32) gefördert wird.

10. Verfahren nach einem der Ansprüche 2, 4, 5, 6 und 7, wobei die Ionenquelle (26) separat von dem Gasstrom in die Kammer (40) gefördert wird.

11. Verfahren nach irgendeinem vorhergehenden Anspruch, wobei der Gasstrom separat von dem Plasmastrom in die Kammer gefördert wird.

12. Verfahren nach Anspruch 3, wobei die Ionenquelle (26) innerhalb des Gasstroms zu dem Plasmastrom gefördert wird.

13. Verfahren nach irgendeinem vorhergehenden Anspruch, wobei der Plasmastrom im Bereich oder unterhalb des atmosphärischen Drucks erzeugt wird.

14. Verfahren nach irgendeinem vorhergehenden Anspruch, wobei der Plasmastrom unter Verwendung eines DC-Plasmabrenners (42) erzeugt wird.

15. Verfahren nach irgendeinem vorhergehenden Anspruch, wobei die Ionenquelle (26) Wasser oder Wasserdampf umfasst.

16. Verfahren nach einem der Ansprüche 1 bis 14 wobei die Ionenquelle (26) einen Alkohol, z.B. Methanol, Ethanol, Propanol, Propan-2-O1 oder Butanol umfasst.

17. Verfahren nach einem der Ansprüche 1 bis 14, wobei die Ionenquelle (26) Wasserstoff, einen Kohlenwasserstoff, Ammoniak oder ein Paraffin umfasst.

18. Verfahren nach irgendeinem vorhergehenden Anspruch, wobei die Kammer (40) sich auf einer Temperatur im Bereich von Umgebungstemperatur bis 1200°C befindet.

19. Verfahren nach irgendeinem vorhergehenden Anspruch, wobei die Kammer (40) sich auf Umgebungstemperatur befindet.

20. Verfahren nach einem der Ansprüche 1 bis 18, wobei die Kammer (40) sich auf einer Temperatur im Bereich von 400°C bis 1000°C befindet.

21. Verfahren nach irgendeinem vorhergehenden Anspruch, wobei die Kammer (40) sich auf einem Druck im Bereich von 10⁻³ mbar bis 2000 mbar befindet.

22. Verfahren nach irgendeinem vorhergehenden Anspruch, wobei die Ionenquelle (26) über einen Katalysator in die Kammer gefördert wird.

23. Verfahren nach Anspruch 22, wobei der Katalysator Wolfram, Silizium, Eisen, Rhodium oder Platin umfasst.

24. Verfahren nach irgendeinem vorhergehenden Anspruch, wobei der Gasstrom nachfolgend von der Kammer (40) zu einem Nasswäscher (70) gefördert wird.

25. Verfahren nach irgendeinem vorhergehenden Anspruch, wobei der Gasstrom nachfolgend von der Kammer (40) zu einem reaktiven Medium (70) gefördert wird.

26. Verfahren nach irgendeinem vorhergehenden Anspruch, wobei die Perfluoroverbindung CF₄, C₂F₆, CHF₃, C₃F₈, C₄F₈, NF₃ oder SF₆ umfaßt.

27. Einrichtung zum Behandeln eines eine Fluorverbindung enthaltenden Gasstroms, wobei die Einrichtung eine Reaktionskammer (40), Mittel (42) zum Erzeugen eines Plasmastroms aus einem Plasmaquellengas und Einleiten des erzeugten Plasmastroms durch eine Öffnung (44) in die Kammer (40), Mittel (30, 28) zum Fördern einer Quelle (26) von OH⁻- und/oder H⁺-Ionen zu dem Plasmastrom zum Auftreffen auf dem Plasmastrom zum Bilden von erhitzten OH⁻- und/oder H⁺-Ionen, und Mittel (18, 20) zum Fördern des Gasstroms zu den erhitzten Ionen aufweist, wobei die Mittel (28, 30) zum Fördern der Quelle von OH-- und/oder H⁺-Ionen dafür angeordnet sind, die Quelle von OH-- und/oder H⁺-Ionen vor dem Einleiten des Plasmastroms in die Kammer (40) zu dem Plasmastrom zu fördern, und die Mittel (18, 20) zum Fördern des Gasstroms zu den erhitzten OH⁻- und/oder H⁺-Ionen dafür angeordnet sind, den Gasstrom direkt zu der Kammer (40) zu fördern.

28. Einrichtung zum Behandeln eines eine Fluorverbindung enthaltenden Gasstroms, wobei die Einrichtung eine Reaktionskammer (40), Mittel (42) zum Erzeugen eines Plasmastroms aus einem Plasmaquellengas und zum Einleiten des erzeugten Plasmastroms durch eine Öffnung (44) in die Kammer (40), Mittel (30, 38) zum Fördern einer Quelle (26) von OH-- und/oder H⁺-Ionen zu dem Plasmastrom zum Auftreffen auf dem Plasmastrom zum Bilden von erhitzten OH⁻- und/oder H⁺-Ionen, und Mittel (18, 20) zum Fördern des Gasstroms zu den erhitzten Ionen aufweist, wobei die Mittel (28, 30) zum Fördern der Quelle von OH⁻- und/oder H⁺-Ionen dafür angeordnet sind, die Quelle von OH-- und/oder H⁺-Ionen zu der Kammer (40) zu fördern, und die Mittel (18, 20) zum Fördern des Gasstroms zu den erhitzten OHund/oder H⁺-Ionen dafür angeordnet ist, den Gasstrom direkt zu der Kammer (40) zu fördern.

29. Einrichtung zum Behandeln eines eine Fluorverbindung enthaltenden Gasstroms, wobei die Einrichtung eine Reaktionskammer (40), Mittel (42) zum Erzeugen eines Plasmastroms aus einem Plasmaquellengas und zum Einleiten des erzeugten Plasmastroms durch eine Öffnung (44) in die Kammer (40), Mittel (30, 28) zum Fördern einer Quelle (26) von OH-- und/oder H⁺-Ionen zu dem Plasmastrom zum Auftreffen auf dem Plasmastrom zum Bilden von erhitzten OH⁻- und/oder H⁺-Ionen, und Mittel (18, 20) zum Fördern des Gasstroms zu den erhitzten Ionen aufweist, wobei die Mittel (18, 20) zum Fördern des Gasstroms zu den erhitzten OH⁻- und/oder H⁺-Ionen dafür angeordnet sind, den Gasstrom zu der Kammer (40) durch die Öffnung (44) mit dem Plasmastrom zu fördern.

30. Einrichtung nach einem der Ansprüche 27, 28 und 29, wobei die Mittel (42) zum Erzeugen eines Plasmastroms Mittel zum Erzeugen eines elektrischen Felds zwischen zwei Elektroden (48, 54 oder 60) und Mittel zum Fördern des Plasmaquellengases zwischen den Elektroden (48, 54 oder 60) hindurch zum Bilden des Plasmastroms aufweisen.

31. Einrichtung nach Anspruch 30, wobei eine der Elektroden (60) mindestens einen Teil einer Wand der genannten Kammer bildet.

32. Einrichtung nach Anspruch 30 oder Anspruch 31, wobei die Öffnung (44) in einer der Elektroden (54) angeordnet ist.

33. Einrichtung nach einem der Ansprüche 27 bis 32, wobei die Mittel (28, 30) zum Fördern der Quelle von OH-- und/oder H⁺-Ionen zu dem Plasmastrom getrennt von den Mitteln (18, 20) zum Fördern des Gasstroms zu den erhitzten OH-- und/oder H⁺-Ionen sind.

## Revendications

1. Procédé de traitement d'un flux gazeux contenant un composé fluoré, le procédé comprenant la génération d'un flux de plasma à partir d'un gaz (32) source de plasma, l'injection, dans une chambre (40), par une ouverture (44), du flux de plasma généré et, avant l'injection du flux de plasma dans la chambre (40), l'acheminement jusqu'au flux de plasma d'une source (26) d'ions OH⁻ et/ou H⁺ destinés à entrer en collision avec le flux de plasma pour former des ions OH⁻ et/ou H⁺ chauffés, et l'acheminement direct du flux de gaz jusqu'à la chambre (40) pour y réagir avec les ions chauffés.

2. Procédé de traitement d'un flux gazeux contenant un composé fluoré, le procédé comprenant la génération d'un flux de plasma à partir d'un gaz (32) source de plasma, l'injection, dans une chambre (40), par une ouverture (44), du flux de plasma généré, l'acheminement jusqu'au flux de plasma d'une source (26) d'ions OH⁻ et/ou H⁺ destinés à entrer en collision avec le flux de plasma pour former des ions OH⁻ et/ou H⁺ chauffés, dans lequel la source d'ions (26) est acheminée jusqu'à la chambre (40), et l'acheminement direct du flux de gaz jusqu'à la chambre (40) pour y réagir avec les ions chauffés.

3. Procédé de traitement d'un flux gazeux contenant un composé fluoré, le procédé comprenant la génération d'un flux de plasma à partir d'un gaz (32) source de plasma, l'injection, dans une chambre (40), par une ouverture (44), du flux de plasma généré, l'acheminement jusqu'au flux de plasma d'une source (26) d'ions OH⁻ et/ou H⁺ destinés à entrer en collision avec le flux de plasma pour former des ions OH⁻ et/ou H⁺ chauffés, et l'acheminement du flux de gaz jusqu'aux ions chauffés par l'intermédiaire du flux de plasma, dans lequel le flux de gaz est acheminé jusqu'au flux de plasma pour injection dans la chambre avec celui-ci.

4. Procédé selon l'une quelconque des revendications précédentes, dans lequel le gaz (32) source de plasma comprend un gaz inerte ionisable, par exemple l'un d'entre l'azote et l'argon.

5. Procédé selon l'une quelconque des revendications précédentes, dans lequel le flux de plasma est formé par génération d'un champ électrique entre deux électrodes (48, 54 ou 60), et par acheminement du gaz (32) source de plasma entre les électrodes pour former le flux de plasma.

6. Procédé selon la revendication 5, dans lequel l'une des électrodes (60) forme une partie au moins d'une paroi de ladite chambre (40).

7. Procédé selon la revendication 5 ou la revendication 6, dans lequel le flux de plasma est injecté dans la chambre (40) par une ouverture (44) formée dans l'une des électrodes (54 ou 60).

8. Procédé selon l'une quelconque des revendications 1, 4, 5, 6 et 7, dans lequel la source (26) d'ions est acheminée jusqu'au flux de plasma dans un flux comprenant le gaz (32) source de plasma.

9. Procédé selon l'une quelconque des revendications 1, 4, 5, 6 et 7, dans lequel la source (26) d'ions est acheminée jusqu'au flux de plasma séparément du gaz (32) source de plasma.

10. Procédé selon l'une quelconque des revendications 2, 4, 5, 6 et 7, dans lequel la source (26) d'ions est acheminée dans la chambre (40) séparément du flux de gaz.

11. Procédé selon l'une quelconque des revendications précédentes, dans lequel le flux de gaz est acheminé jusqu'à la chambre séparément du flux de plasma.

12. Procédé selon la revendication 3, dans lequel la source (26) d'ions est acheminée jusqu'au flux de plasma dans le flux de gaz.

13. Procédé selon l'une quelconque des revendications précédentes, dans lequel le flux de plasma est généré à une pression proche ou au-dessous de la pression atmosphérique.

14. Procédé selon l'une quelconque des revendications précédentes, dans lequel le flux de plasma est généré en utilisant une torche (42) à plasma à courant continu.

15. Procédé selon l'une quelconque des revendications précédentes, dans lequel la source (26) d'ions comprend l'une d'entre l'eau et la vapeur d'eau.

16. Procédé selon l'une quelconque des revendications 1 à 14, dans lequel la source (26) d'ions comprend un alcool, par exemple l'un d'entre le méthanol, l'éthanol, le propanol, le propan-2-ol et le butanol.

17. Procédé selon l'une quelconque des revendications 1 à 14, dans lequel la source (26) d'ions comprend l'un d'entre l'hydrogène, un hydrocarbure, l'ammoniac et une-paraf fine.

18. Procédé selon l'une quelconque des revendications précédentes, dans lequel la chambre (40) est à une température comprise dans une plage allant de la température ambiante à 1200°C.

19. Procédé selon l'une quelconque des revendications précédentes, dans lequel la chambre (40) est à température ambiante.

20. Procédé selon l'une quelconque des revendications 1 à 18, dans lequel la chambre (40) est à une température comprise dans la plage de 400°C à 1000°C.

21. Procédé selon l'une quelconque des revendications précédentes, dans lequel la chambre (40) est à une pression comprise dans la plage de 10⁻³ mbar à 2000 mbar.

22. Procédé selon l'une quelconque des revendications précédentes, dans lequel la source (26) d'ions est acheminée jusqu'à l'intérieur de la chambre sur un catalyseur.

23. Procédé selon la revendication 22, dans lequel le catalyseur comprend l'un d'entre tungstène, silicium, fer, rhodium et platine.

24. Procédé selon l'une quelconque des revendications précédentes, dans lequel le flux de gaz est ensuite acheminé de la chambre (40) jusqu'à un dépoussiéreur hydraulique (70).

25. Procédé selon l'une quelconque des revendications précédentes, dans lequel le flux de gaz est ensuite acheminé de la chambre (40) jusqu'à un milieu réactif (70).

26. Procédé selon l'une quelconque des revendication précédentes, dans lequel le composé perfluoré comprend l'un d'entre CF₄, C₂F₆, CHF₃, C₃F₈, C₄F₈, NF₃ et SF₆.

27. Dispositif pour le traitement d'un flux de gaz contenant un composé fluoré, le dispositif comprenant une chambre de réaction (40), des moyens (42) pour générer un flux de plasma à partir d'un gaz source de plasma et pour injecter le flux de plasma généré par une ouverture (44) dans la chambre (40), des moyens (30, 28) pour acheminer jusqu'au flux de plasma une source (26) d'ions OH⁻ et/ou H⁺ pour qu'ils entrent en collision avec le flux de plasma pour former des ions OH⁻ et/ou H⁺ chauffés, et des moyens (18, 20) pour acheminer le flux de gaz jusqu'aux ions chauffés, dans lequel les moyens (28, 30) pour acheminer la source d'ions OH⁻ et/ou H⁺ sont prévus pour acheminer la source d'ions OH⁻ et/ou H⁺ jusqu'au flux de plasma avant l'injection du flux de plasma dans la chambre (40), et les moyens (18, 20) pour acheminer le flux de gaz jusqu'aux ions OH⁻ et/ou H⁺ chauffés sont prévus pour acheminer directement le flux de gaz jusqu'à la chambre (40).

28. Dispositif pour le traitement d'un flux de gaz contenant un composé fluoré, le dispositif comprenant une chambre de réaction (40), des moyens (42) pour générer un flux de plasma à partir d'un gaz source de plasma et pour injecter le flux de plasma généré par une ouverture (44) dans la chambre (40), des moyens (30, 28) pour acheminer jusqu'au flux de plasma une source (26) d'ions OH⁻ et/ou H⁺ pour qu'ils entrent en collision avec le flux de plasma pour former des ions OH- et/ou H⁺ chauffés, et des moyens (18, 20) pour acheminer le flux de gaz jusqu'aux ions chauffés, dans lequel les moyens (28, 30) pour acheminer la source d'ions OH⁻ et/ou H⁺ sont prévus pour acheminer la source d'ions OH⁻ et/ou H⁺ jusqu'à la chambre (40), et les moyens (18, 20) pour acheminer le flux de gaz jusqu'aux ions OH⁻ et/ou H⁺ chauffés sont prévus pour acheminer directement le flux de gaz jusqu'à la chambre (40).

29. Dispositif pour le traitement d'un flux de gaz contenant un composé fluoré, le dispositif comprenant une chambre de réaction (40), des moyens (42) pour générer un flux de plasma à partir d'un gaz source de plasma et pour injecter le flux de plasma généré par une ouverture (44) dans la chambre (40), des moyens (30, 28) pour acheminer jusqu'au flux de plasma une source (26) d'ions OH⁻ et/ou H⁺ pour qu'ils entrent en collision avec le flux de plasma pour former des ions OH⁻ et/ou H⁺ chauffés, et des moyens (18, 20) pour acheminer le flux de gaz jusqu'aux ions chauffés, dans lequel les moyens (18, 20) pour acheminer le flux de gaz jusqu'aux ions OH⁻ et/ou H⁺ chauffés sont prévus pour acheminer le flux de gaz jusqu'à la chambre (40) par l'ouverture (44) avec le flux de plasma.

30. Dispositif selon l'une des revendications 27, 28 et 29, dans lequel les moyens (42) pour générer un flux de plasma comprennent des moyens pour générer un champ électrique entre deux électrodes (48, 54 ou 60), et des moyens pour acheminer le gaz source de plasma entre les électrodes (48, 54 ou 60) pour former le flux de plasma.

31. Dispositif selon la revendication 30, dans lequel l'une des électrodes (60) forme une partie au moins d'une paroi de ladite chambre.

32. Dispositif selon la revendication 30 ou la revendication 31, dans lequel l'ouverture (44) est située dans l'une des électrodes (54).

33. Dispositif selon l'une quelconque des revendications 27 à 32, dans lequel les moyens (28, 30) pour acheminer la source d'ions OH⁻ et/ou H⁺ jusqu'au flux de plasma sont séparés des moyens (18, 20) pour acheminer le flux de gaz jusqu'aux ions OH⁻ et/ou H⁺ chauffés.
